Europäisches Patentamt

European Patent Office

Office européen des brevets

(11) Publication number: **0 068 064**
A1

# EUROPEAN PATENT APPLICATION

(21) Application number: **82100162.5**

(22) Date of filing: **12.01.82**

(51) Int. Cl.³: **H 01 L 29/76, H 01 L 29/205**

(30) Priority: **30.06.81 US 280141**

(43) Date of publication of application: **05.01.83**
Bulletin **83/1**

(84) Designated Contracting States: **DE FR GB IT**

(71) Applicant: **International Business Machines Corporation, Armonk, N.Y. 10504 (US)**

(72) Inventor: **Esaki, Leo, 16 Shady Lane, Chappaqua New York 10514 (US)**

(74) Representative: **Hobbs, Francis John, IBM United Kingdom Patent Operations Hursley Park, Winchester Hants, SO21 2JN (GB)**

(54) Semiconductor circuit including a resonant quantum mechanical tunnelling triode device.

(57) A semiconductor circuit includes a triode device (1) wherein majority carrier transport is by quantum mechanical resonant tunnelling through two barriers. The device is constructed of three layers (2, 3, 4) of the same conductivity type monocrystalline semiconductor material. There are identical barriers between the first (2) and second (3) layers and the second (3) and third (4) layers. The layers are doped and biased so that electrons are in all three layers. The width and doping of the second layer (3) are such that it provides a potential well with lower ($E_1$) and higher ($E_2$) quasistationary energy states. The bias voltages applied to the second (3) and third (4) layers cause the higher quasistationary energy state ($E_2$) to be aligned with the Fermi level ($E_f$) in the first layer (2). The device provides switching speeds of the order of $10^{-12}$ seconds.

ACTORUM AG

0068064

## SEMICONDUCTOR CIRCUIT INCLUDING A RESONANT QUANTUM MECHANICAL TUNNELLING TRIODE DEVICE

This invention relates to semiconductor circuits including resonant tunnelling triode devices.

Development of semiconductor devices of the triode, three-terminal or transistor type has led to devices having progressively shorter switching times.  As the performance advances, however, the standard mode of operation which has involved minority carrier motion by diffusion has been becoming an increasingly significant limitation.

The phenomenon of resonant tunnelling has been reported in Applied Physics Letters, Vol. 24, No. 12, 15 June 1974, pages 593 to 595.  In this type of carrier transport under appropriate conditions the carriers have the same momentum in all places and phonon transitions are not involved.

The invention seeks to provide a semiconductor circuit including a triode device the operation of which involves quantum mechanical tunnelling.

A semiconductor circuit according to the invention, includes a triode device comprising a monocrystalline semiconductor body having first and third layers on opposite sides of a second layer, each layer being of the same conductivity type, said first and third layers each forming a barrier with said second layer of quantum mechanical tunnelling type, said second layer having such a width and doping that a potential well with a higher and a lower quasistationary energy state is present in said second layer with a Fermi energy level above said lower energy state; and a bias voltage source arranged to apply such bias voltages to said second and third layers with respect to said first layer that said higher quasistationary energy state is aligned with the Fermi level in said first layer.

How the invention can be carried out will now be described by way
of example, with reference to the accompanying drawings, in which:-

FIG. 1 is a schematic of a triode semiconductor device;

FIG. 2 is an energy level diagram of the device of FIG. 1 in an
unbiased condition, the diagram being dimensionally correlated with the
structure of FIG. 1;

FIG. 3 is an energy level diagram, similar to that of FIG. 2, but
with the device in a biased condition; and

FIG. 4 is a collector current against base voltage characteristic
showing a peak in collector current that is the result of resonant
tunnelling in the triode device.

In a circuit in accordance with the invention, the physical structure
of a triode and the bias applied to it cooperate to permit controllable
majority carrier flow by the phenomenon of resonant quantum mechanical
tunnelling.

The combination of a potential well produced between two identical
tunnelling barriers, selection of potential well and barrier thicknesses, the provision of a control electrode to the region of the
potential well and the establishment of specific biasing related to the
Fermi level provides a triode device the operation of which involves
carrier transport by resonant tunnelling. There are two quasistationary
energy states in the potential well region of the device and the bias
voltages at which maximum transport occurs are at about twice the energy
state values. Under these conditions, majority carriers tunnel through
both barriers, the output or collector current vs. collector voltage
variation exhibits a substantial peak at the appropriate bias level and
conduction is controlled by a signal applied to the potential well
region.

Since electrons have higher mobility and since most devices are constructed using electrons as majority carriers, the following discussion and illustrations are directed to electron flow; it being understood, however, that one skilled in this art could readily make the appropriate substitutions in the light of the principles set forth, for conversion to the use of holes as majority carriers.

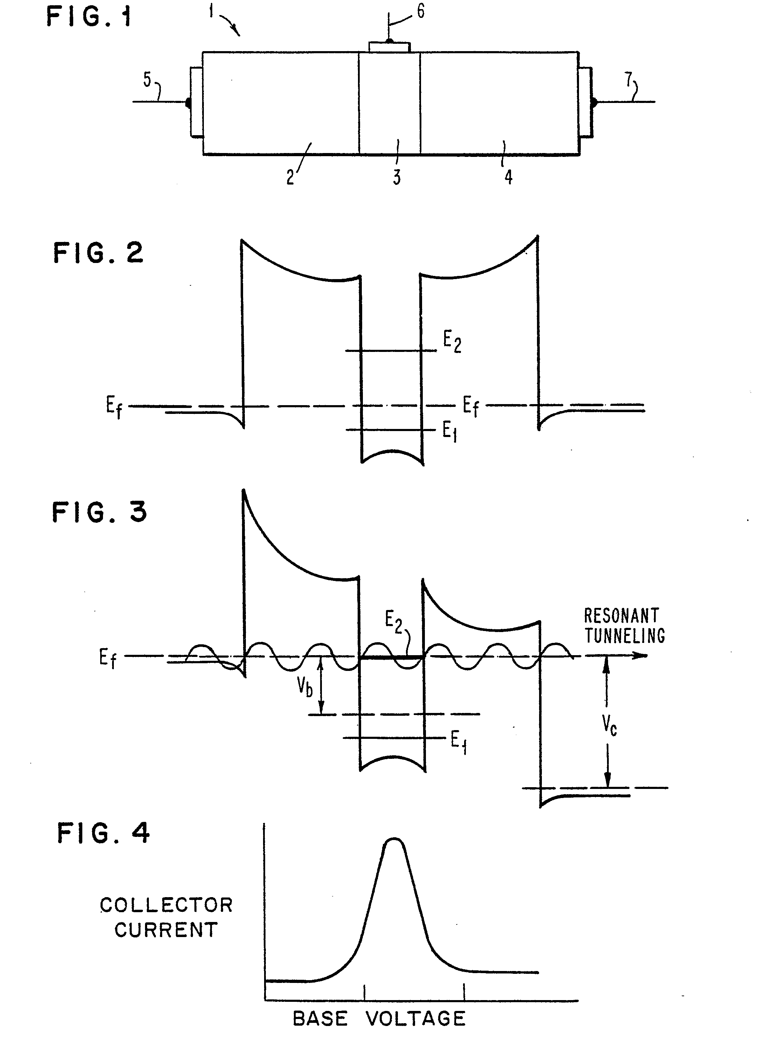

Referring to FIG. 1, a resonant tunnelling triode device consists of a single crystal semiconductor body 1 having an external region performing the function in a three-terminal device of an emitter region 2, a potential well region performing the function of a base region 3, and an external region performing the function of a collector region 4, each region having the same n conductivity type. Ohmic contacts 5, 6 and 7 are provided to the emitter, the base and the collector regions, respectively.

In accordance with the invention, the device has a number of dimensional and biasing constraints that in combination produce the controllable resonant tunnelling current flow. The base or potential well region 3 is of a width such that tunnelling majority carriers are not attenuated in traversing the base to the collector barrier and a potential well is established with a high $E_2$ and a low $E_1$ quasistationary energy level. The emitter injecting barrier and the collecting barrier should be identical in width and height as shown in FIG. 2. The barriers should have a width and height suitable for quantum mechanical tunnelling and a height such that a bias on the collector and on the base will align the Fermi level with the higher quasistationary energy state.

Referring to FIG. 2, an energy level diagram is illustrated. The potential well or base region is of gallium arsenide doped to $10^{18} cm^{-3}$ and has a width of 50 Angstroms. The emitter region 2 and the collector regtion 4 are of $Ga_{0.3}Al_{0.7}As$ doped to $10^{19}cm^{-3}$ and of 100 Angstroms thickness each.   Such a structure can be fabricated by the techniques of molecular beam epitaxy (MBE) or chemical vapour depostion (CVD).

Under these structural conditions, the Fermi level labelled $E_f$ in FIG. 2 in the base region 3 would be approximately 0.15 electron volts above the lower level $E_1$, and the energy level in both the emitter 2 and the collector 4 regions in the vicinity of the ohmic contacts 5 and 7 would be in the vicinity of the Fermi level.

In the base region 3, the level of the lower quasistationary state energy $E_1$ is approximately 0.08 electron volts above the lowest level in the base and the value of the higher quasistationary level $E_2$ is approximately 0.28 electron volts above the lowest level.   The $Ga_{0.3}Al_{0.7}As$-GaAs interfaces would have identical barriers of less than 1 electron volt.

The application of bias with the emitter connected to reference voltage as is illustrated in FIG. 3 of approximately 0.3 volts labelled $V_c$ on the collector 4 and of approximately 0.13 volts labelled $V_b$ on the base 3 operates to cause the $E_2$ energy level in the base 3 to be at the same potential as the Fermi level in the emitter and the phenomenon of resonant tunnelling provides carrier flow from emitter to collector under control of an appropriate signal on the base.

Referring next to FIG. 4, a graph of the variation in collector current with base voltage is illustrated wherein as the collector voltage is increased, a peak current region is encountered at the level of resonant mechanical tunnelling.

The current characteristic curve for the preferred embodiment described where the collector voltage is 0.3 volts exhibits a peak that

0068064

begins at approximately 0.1 volt base voltage and ends at approximately 0.2 volts.  The peak is on average about 0.13 volts in width.

What has been described is a technique of applying the phenomenon of resonant quantum mechanical tunnelling to a triode device wherein the base transport is by majority carrier resonant tunnelling through two barriers which serve as emitter and collector of the transistor.  The device has three layers of the same conductivity type and exhibits switching speeds of the order of $10^{-12}$ seconds.

CLAIMS

1.   A semiconductor circuit including a semiconductor triode comprising a monocrystalline semiconductor body having first (2) and third (4) layers on opposite sides of a second layer (3), each layer being of the same conductivity type, said first and third layers each forming a barrier with said second layer of quantum mechanical tunnelling type, said second layer having such a width and doping that a potential well with a higher and a lower quasistationary energy state is present in said second layer with a Fermi energy level above said lower energy state; and a bias voltage source arranged to apply such bias voltages to said second and third layers with respect to said first layer that said higher quasistationary energy state is aligned with the Fermi level ($E_f$) in said first layer.

2.   A circuit as claimed in claim 1, wherein said bias voltage source is arranged to apply a bias to said third layer equal to twice the potential from the lowest energy level in said second layer to said Fermi level.

3.   A circuit as claimed in claim 1 or claim 2, wherein said second layer is 50Å wide and consists of GaAs doped to $10^{18}$cm$^3$, and said first and third layers are 100Å wide and consist of $Ga_{.3}Al_{.7}As$ doped to $10^{19}$cm$^3$.

4.   A circuit as claimed in claim 3, wherein said bias voltage source is arranged to apply 0.3V to said third layer and 0.13V to said second layer, said first layer being connected to reference voltage.

FIG. 1

FIG. 2

FIG. 3

FIG. 4

0068064

0068064

## EUROPEAN SEARCH REPORT

European Patent Office

Application number

EP 82 10 0162.5

| | DOCUMENTS CONSIDERED TO BE RELEVANT | | CLASSIFICATION OF THE APPLICATION (Int. Cl. 3) |
|---|---|---|---|
| Category | Citation of document with indication, where appropriate, of relevant passages | Relevant to claim | |
| X | DE - A1 - 2 607 940 (MAX-PLANCK-GESELL-SCHAFT) <br> * page 20, first paragraph to page 22, last paragraph * <br> -- | 1,3 | H 01 L 29/76 <br> H 01 L 29/205 |
| A,D | APPLIED PHYSICS LETTERS, Vol. 24, No. 12 <br> 15 June 1974, New York <br> L.L. CHANG et al. "Resonant Tunneling in Semiconductor Double Barriers" <br> pages 593 to 595 <br> * page 593, last paragraph to page 594, first paragraph * <br> -- | 1,2,4 | |
| A | IBM TECHNICAL DISCLOSURE BULLETIN <br> Vol. 21, No. 4, September 1978, New York <br> C.-A. CHANG et al. "Semiconductor Hetero-structure Devices" <br> pages 1689 to 1690 <br> ---- | | |

**TECHNICAL FIELDS SEARCHED (Int.Cl. 3)**

H 01 L 29/20
H 01 L 29/225
H 01 L 29/267
H 01 L 29/72
H 01 L 29/76

**CATEGORY OF CITED DOCUMENTS**

X: particularly relevant if taken alone
Y: particularly relevant if combined with another document of the same category
A: technological background
O: non-written disclosure
P: intermediate document
T: theory or principle underlying the invention
E: earlier patent document, but published on, or after the filing date
D: document cited in the application
L: document cited for other reasons

&: member of the same patent family, corresponding document

X The present search report has been drawn up for all claims

| Place of search | Date of completion of the search | Examiner |
|---|---|---|
| Berlin | 22-09-1982 | GIBBS |

EPO Form 1503.1   06.78